# EUROPÄISCHE PATENTSCHRIFT

(11) **EP 1 160 568 B1**
(45) Veröffentlichungstag und Bekanntmachung des Hinweises auf die Patenterteilung: **02.02.2005**
(21) Anmeldenummer: 01111797.5
(22) Anmeldetag: 15.05.2001
(51) Int. Cl.: G01N 31/22

(54) **Verfahren und Testflüssigkeit zum Nachweisen von sauren Flussmittelrückständen an elektronischen Baugruppen**
Method and composition for detecting acid residues on electronic components
Procédé et composition pour la détection des résidus acidiques sur un composant électronique

(30) Priorität: 31.05.2000 DE 10027236
(43) Veröffentlichungstag der Anmeldung: 05.12.2001
(73) Patentinhaber: DR.O.K. WACK CHEMIE GmbH, D-85053 Ingolstadt (DE)
(72) Erfinder: Schweigart, Helmut, Dr., 85049 Ingolstadt (DE)
(74) Vertreter: Kramer - Barske - Schmidtchen

(56) Entgegenhaltungen:
- EP-A- 0 602 551
- EP-A- 1 004 880
- DE-A- 2 938 545
- DE-A- 19 607 795
- US-A- 4 858 465
- US-A- 4 894 346
- US-A- 4 956 301
- US-A- 5 773 982

## Beschreibung

Die Erfindung betrifft ein Verfahren und eine Testflüssigkeit zum Nachweisen von sauren Flussmittelrückständen an elektronischen Baugruppen.

Die Zuverlässigkeit elektronischer Schaltungen wird wesentlich durch Verunreinigungen von deren Oberflächen beeinträchtigt. Insbesondere in beim Löten verwendeten Flussmitteln enthaltene Carbonsäuregruppen wirken hygroskopisch und können in Verbindung mit ungünstigen klimatischen Bedingungen, wie Feuchtigkeit, zu elektrochemischer Migration oder zu Kriechströmen führen, die u. U. die Funktionstüchtigkeit der elektronischen Schaltung bzw. Baugruppe beeinträchtigt oder sogar zu deren Ausfall führt.

Zur Beurteilung von etwa vorhandenen Verunreinigungen, insbesondere Rückständen von Flussmitteln, die Carbonsäuregrüppen enthalten, sind bisher im wesentlichen zwei Verfahren üblich:

Bei einem ersten Verfahren wird die sogenannte ionische Restkontamination bestimmt. Dazu wird die zu überprüfende Baugruppe in destilliertes Wasser eingebracht und die Leitfähigkeit des Wassers, die durch die sauren Gruppen der Flussmittelrückständen ansteigt, gemessen. Diese Leitfähigkeit wird in Beziehung zu einer Natriumchloridmenge gesetzt, deren Zusatz zu dem destilliertem Wasser die gleiche Leitfähigkeit ergeben würde. Die Aussagekraft dieses ionischen Rest-Kontaminationsverfahrens ist begrenzt, da bestimmte Verunreinigungen in Wasser überhaupt nicht löslich sind und deshalb nicht erfasst werden. Weiterhin müsste die Zusammensetzung der Verunreinigung genau bekannt sein, um einen beispielsweise an die Korrosionswirksamkeit der Verunreinigung angepassten Grenzwert angeben zu können. Außerdem ist die Investition in ein Prüfgerät zur Kontrolle der ionischen Restkontamination verhältnismäßig teuer.

Das zweite Verfahren ist ein aufwendiges Ladungskontrastverfahren, das mit einem Rasterelektronenmikroskop durchgeführt wird. Mit diesem Verfahren können Verunreinigungen von auf zunächst unter lichtoptischen Untersuchungsbedingungen sauber erscheinenden Oberflächen sichtbar gemacht werden. Das Verfahren ist sehr teuer und wird deshalb nur begrenzt eingesetzt.

Die DE 196 07 795 A1 beschreibt ein Verfahren zur Untersuchung ionischer Verunreinigungen elektronischer Bauteile, das auf dem Prinzip einer Leitfähigkeitsänderung beruht.

Die US-A-4,858,465 betrifft ein mehrstufiges Verfahren zum Nachweisen und visuellen Lokalisieren von Verunreinigungen auf einem Gegenstand. Die Zusammensetzung, die dabei zum Nachweis der vorstehend genannten Verunreinigungen dient, ist eine wässrige Flüssigkeit, die Wasser, einen Polyglykolether als Tensid und einen von Nilblau verschiedenen Fluoreszenzfarbstoff enthält.

Die US-A-4,894,346 beschreibt ein Verfahren zur kolorimetrischen Bestimmung der Konzentration von Sulfonat- und/oder Polycarboxylatverbindungen in wässriger Lösung unter Verwendung von z.B. Nilblau A als Indikatorfarbstoff.

Die US-A-4,956,301 betrifft eine Testvorrichtung und ein Testverfahren zur Bestimmung der Gegenwart und der Konzentration von Fructosaminen in einer Testprobe, sowie eine Indikätorreagenzzusammensetzung dafür. Die Indikatorreagenzzusammensetzung umfasst einen Farbstoff, einen geeigneten Puffer und eine Beschleunigerverbindung, bei der es sich um nichtionische Tenside wie z.B. ethoxylierte oder propoxylierte Fettalkohole oder fluorierte Alkylpolyoxyethylenethanol-Tenside handeln kann.

Der Erfindung liegt die Aufgabe zugrunde, ein Verfahren zum Nachweisen von sauren Flussmittelrückständen an elektronischen Baugruppen anzugeben, das bei kostengünstiger Durchführbarkeit zu sicheren Ergebnissen führt. Der Erfindung liegt weiter die Aufgabe zugrunde, eine Testflüssigkeit anzugeben, mit der das erfindungsgemäße Verfahren durchgeführt werden kann.

Die vorstehend genannten Aufgaben werden durch das Verfahren nach Anspruch 1 und die Testflüssigkeit nach Anspruch 8 gelöst . Vorteilhafte weiterbildungen der Erfindung sind in den abhängigen Ansprüchen angegeben.

Bei dem erfindungsgemäßen Verfahren, wird zunächst eine Testflüssigkeit, die einen unter einer Farbänderung mit den Verunreinigungen, insbesondere den Flussmittelrückständen, reagierenden Farbstoff enthält, auf die elektronische Baugruppe aufgebracht und die Testflüssigkeit dann nach einer ausreichend langen Reaktionszeit abgewaschen. Die verunreinigten Bereiche, in denen mit dem Farbstoff unter dessen Farbänderung reagierende Verunreinigungen vorhanden sind, sind dann als entsprechend gefärbte Bereiche unmittelbar durch visuelle Inspektion oder mit Hilfe optischen Scannens erfassbar und identifizierbar, sodass eine sichere Beurteilung der elektronischen Baugruppe im Hinblick auf deren Funktionsbeeinträchtigung durch die erfassten Rückstände möglich ist. Die Testflüssigkeit enthält den Farbstoff Nilblau und ein Tensid zur Verbesserung des Benetzungsvermögens der Testflüssigkeit.

Das erfindungsgemäße Verfahren ist außerordentlich einfach durchführbar, vielseitig einsetzbar und führt zu sicheren Ergebnissen. Die im Hinblick auf das Vorhandensein von Flussmittelrückständen zu untersuchenden elektronischen Baugruppen können einfache Leiterplatten, aber auch komplexe Schaltungsstrukturen mit auf unterschiedlichste Weise aufgebrachten Bauelementen sein. Die dabei eingesetzten Lötverfahren können manuelle Lötungen, maschinelle Lötungen, wie sie bei einer SMD-Bestückung eingesetzt werden, oder auch Tauchlötverfahren sein.

Als Farbstoff der mit den entsprechenden Gruppen der Flussmittelrückstände eine Farbreaktion zeigt wird Nilblau eingesetzt. Die Reaktion des Farbstoffes mit den sauren Aktivator-Rückständen des Flussmittels löst eine Veränderung der chemischen Struktur des Farbstoffes aus, die zu einer Verfärbung führt. Die meist farblosen Aktivator-Rückstände werden somit sichtbar.

Mit dem als Farbstoff eingesetzten Nilblau (5-Amino-9-(diethylamino)benzo-[a]phenoxazin-7-iumhydrogensulfat), das bevorzugt als Nilblau-Hydrogensulfat eingesetzt wird, werden ausgezeichnete Ergebnisse erzielt. Er kann auch in Form eines -sulfats, -chlorids oder anderen Salzes eingesetzt werden. Die sauren Gruppen, beispielsweise Carbonsäuren bzw. Carboxylgruppen von Flussmitteln, führen zu einer Blaufärbung, die auf einer Säure-Base-Gleichgewichtsreaktion gem. nachfolgendem Schema beruht, wobei ein Sulfation jeweils durch ein Carboxylation ausgetauscht wird.

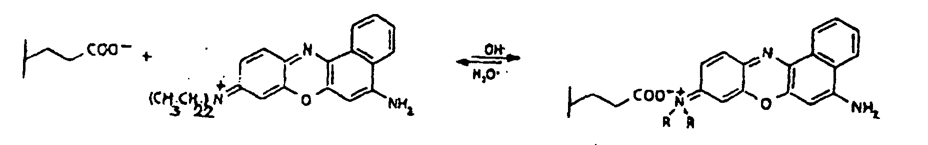

Mit der Blaufärbung des Farbstoffs Nilblau können Rückstände aller üblichen Flussmittel nachgewiesen werden, insbesondere, wenn diese Carbonsäuren enthalten. Auch Rückstände sog. No-Clean Flussmittel, die besonders feststoffarm sind, sind mit Nilblau nachweisbar.

Ein Problem, das sich in der Praxis häufig stellt, ist, dass der Farbstoff der Testflüssigkeit nicht an die reaktiven Gruppen der Verunreinigungen herankommt. Dieses Problem wird erfindungsgemäß dadurch gelöst, dass der den Farbstoff Niblau enthaltenden, vorzugsweise wässrigen Testflüssigkeit ein aus Polyglykolethern oder Fluortensiden ausgewähltes Tensid zugesetzt, um die Oberflächenspannung der Testflüssigkeit herabzusetzen und damit deren Benetzungsvermögen zu verbessern. Dabei werden bevorzugt nichtionische Tenside eingesetzt, deren Reste chemisch inert sind und die keinerlei Reaktion mit dem Farbstoff eingehen.

Geeignet sind beispielsweise:
C₁₂/C₁₄-Fettalkoholpolyglykolether mit 3 Ethylenoxideinheiten oder
C₁₄/C₁₅-Oxoalkoholpolyglykolether mit 3 Ethylenoxideinheiten oder
C₁₂/C₁₅-Oxoalkoholpolyglykolether mit 3 bis 5 Ethylenoxideinheiten.

Sehr gute Benetzungen, vor allem von Kunststoffoberflächen, werden mit Fluortensiden erzielt. Solche Fluortenside erniedrigen die Oberflächenspannung wässriger Lösungen auf Werte von etwa 20 mN/m². Bevorzugt werden Fluortenside der allgemeinen Formel

R_{f}CH₂CH₂O(CH₂CH₂O)ₓH

wobei 3 ≤ x≤ 5 und R_{f} = F(CF₂CF₂)ₙ mit 3 ≤ n ≤ 8.

Die genannten oder andere Tenside können einzeln oder in Kombination vorhanden sein.

Vorteilhaft hat die Testflüssigkeit folgende Zusammensetzung (Gewichtsprozente):

| | |
|---|---|
| Nilblau | 0,02 bis 0,06, |
| Tensid | 0,05 bis 0,2 |
| entsalztes Wasser | ad 100 |

Besonders bevorzugt werden 0,04 % Nilblau, 0,1% Fluortensid und 99,86% Wasser.

Das erfindungsgemäße Verfahren wird beispielsweise wie folgt durchgeführt:

Die Testflüssigkeit wird punktuell oder im Bedarfsfall großflächig auf die Lötstelle bzw. die gesamte Oberfläche der zu untersuchenden elektronischen Baugruppe aufgebracht. Nach einer Einwirkdauer von etwa einer Minute wird mit destilliertem oder voll entsalztem Wasser etwa 30 Sekunden lang sorgfältig und kräftig abgespült. Die Baugruppe wird dann getrocknet, wobei beispielsweise trockene und ölfreie Pressluft unterstützend verwendet werden kann.

Zeigen sich keine Verfärbungen, so deutet das daraufhin, dass die Baugruppe frei von Aktivatorrückständen bzw. Säuregruppen ist. Blaue oder Blauviolette Verfärbungen (beim Farbstoff Nilblau), die mit dem bloßen Auge oder im Falle sehr dünner Filme erst unter Betrachtung mit dem Mikroskop mit beispielsweise zwanzigfacher Vergrößerung sichtbar sind, zeigen das Vorhandensein von Aktivatoren bzw. Verunreinigungen an, die für die Funktionstüchtigkeit der elektronischen Baugruppe gravierend nachteilige Folgen haben können.

Es versteht sich, dass die Analyse auf Verfärbungen auch mit Hilfe einer Scanneinrichtung erfolgen kann, die die gesamte Oberfläche der elektronischen Baugruppe abtastet und in dem jeweiligen Spektralbereich gefärbte Bereiche automatisch erfasst.

Mit Nilblau lassen sich auch stark alkalische Gruppen, wie sie in Reinigungsmitteln vorkommen, nachweisen, beispielsweise Aminkomponenten. Solche stark alkalischen Gruppen führen bei Nilblau zu einer Rot-Violett Färbung, die auf einer Zersetzung beispielsweise des Farbstoffs Nilblausulfat führt, die im Alkalischen bei einem pH > 10,2 erfolgt. Keine Verfärbung bedeutet somit, dass keine der vorgenannten reaktiven Gruppen vorhanden ist.

## Patentansprüche

1. Verfahren zum Nachweisen von sauren Flussmittelrückständen an elektronischen Baugruppen, enthaltend folgende Schritte:
Aufbringen einer Testflüssigkeit, die einen unter einer Farbänderung mit den sauren Flussmittelrückständen reagierenden Farbstoff enthält, auf die elektronische Baugruppe, Abwaschen der Testflüssigkeit von der elektronischen Baugruppe und
Erfassen von Oberflächenbereichen der elektronischen Baugruppe, die entsprechend der Farbänderung gefärbt sind, **dadurch gekennzeichnet, dass** die Testflüssigkeit den Farbstoff Nilblau und ein Tensid zur Verbesserung des Benetzungsvermögens der Testflüssigkeit umfasst.

2. Verfahren nach Anspruch 1,bei dem das Tensid ein Polyglykolether ist.

3. Verfahren nach Anspruch 2, bei dem das Tensid ein C₁₂/C₁₅-Oxoalkoholpolyglykolether ist.

4. Verfahren nach Anspruch 3, bei dem der Oxoalkoholpolyglykolether 3 bis 5 Ethylenoxideinheiten enthält.

5. Verfahren nach Anspruch 1, bei dem das Tensid ein Fluortensid ist.

6. Verfahren nach Anspruch 5, bei dem das Fluortensid die allgemeine Formel R_{f}CH₂CH₂O(CH₂CH₂O)ₓH hat, wobei 3 ≤ x ≤ 5 und R_{f}= F(CF₂-CF₂)ₙ mit 3 ≤ n ≤ 8.

7. Verfahren nach einem der Ansprüche 1 bis 6, bei dem die Testflüssigkeit folgende Zusammensetzung (Gewichtsprozente) aufweist:
| | |
|---|---|
| Nilblau | 0,02 bis 0,06 |
| Tensid | 0,05 bis 0,2 |
| entsalztes Wasser | ad 100. |

8. Testflüssigkeit zum Nachweisen von sauren Flussmittelrückständen an elektronischen Baugruppen, die den Farbstoff Nilblau und ein aus Polyglykolethern oder Fluortensiden ausgewähltes Tensid umfasst.

9. Testflüssigkeit nach Anspruch 8, bei der das Tensid ein Polyglykolether ist.

10. Testflüssigkeit nach Anspruch 9, bei der das Tensid ein C₁₂/C₁₅-Oxoalkoholpolyglykolether ist.

11. Testflüssigkeit nach Anspruch 10, bei welcher der Oxoalkoholpolyglykolether 3 bis 5 Ethylenoxideinheiten enthält.

12. Testflüssigkeit nach Anspruch 8, bei der das Tensid ein Fluortensid ist.

13. Testflüssigkeit nach Anspruch 12, bei der das Fluortensid die allgemeine Formel R_{f}CH₂CH₂O(CH₂CH₂O)ₓH hat, wobei 3 ≤ x ≤ 5 und R_{f} = F(CF₂-CF₂)ₙ mit 3 ≤ n ≤ 8.

14. Testflüssigkeit nach einem der Ansprüche 8 bis 13, enthaltend folgende Zusammensetzung (Gewichtsprozente):
| | |
|---|---|
| Nilblau | 0,02 bis 0,06 |
| Tensid | 0,05 bis 0,2 |
| entsalztes Wasser | ad 100. |

## Claims

1. A method for detecting acidic fluxing agent residues on electronic components, wherein the method consists of the following steps:
applying a test liquid containing a dye, which dye changes its colour when reacting with the acidic fluxing agent residues, on the electronic component,
rinsing off the test liquid from the electronic component, and
detecting surface areas of the electronic component, which are coloured according to the change of colour, **characterized in that** the test liquid comprises the dye nile blue and a surfactant for improving the wettability of the test liquid.

2. The method according to claim 1, wherein the surfactant is a polyglycol ether.

3. The method according to claim 2, wherein the surfactant is a C₁₂/C₁₅ oxoalcohol polyglycol ether.

4. The method according to claim 3, wherein the oxoalcohol polyglycol ether contains 3 to 5 ethylene oxide units.

5. The method according to claim 1, wherein the surfactant is a fluoro surfactant.

6. The method according to claim 5, wherein the fluoro surfactant has the general formula R_{f}CH₂CH₂O(CH₂CH₂O)ₓH, wherein 3 ≤ x ≤ 5 and R_{f} = F(CF₂-CF₂)ₙ, wherein 3 ≤ n ≤ 8.

7. The method according to any one of claims 1 to 6, wherein the test liquid has the following composition (% by weight):
| | |
|---|---|
| nile blue | 0,02 to 0,06 |
| surfactant | 0,05 to 0,2 |
| demineralised water | ad 100. |

8. A test liquid for detecting acidic fluxing agent residues on electronic components, comprising the dye nile blue and a surfactant, which is selected from polyglycol ethers or fluoro surfactants.

9. The test liquid according to claim 8, wherein the surfactant is a polyglycol ether.

10. The test liquid according to claim 9, wherein the surfactant is a C₁₂/C₁₅ oxoalcohol polyglycol ether.

11. The test liquid according to claim 10, wherein the oxoalcohol polyglycol ether contains 3 to 5 ethylene oxide units.

12. The test liquid according to claim 8, wherein the surfactant is a fluoro surfactant.

13. The test liquid according to claim 12, wherein the fluoro surfactant has the general formula R_{f}CH₂CH₂O(CH₂CH₂O)ₓH, wherein 3 ≤ x ≤ 5 and R_{f} = F(CF₂-CF₂)ₙ, wherein 3 ≤ n ≤ 8.

14. The test liquid according to any one of claims 8 to 13, wherein the test liquid has the following composition (% by weight):
| | |
|---|---|
| nile blue | 0,02 to 0,06 |
| surfactant | 0,05 to 0,2 |
| demineralised water | ad 100. |

## Revendications

1. Procédé pour la mise en évidence de résidus liquides acides sur des composants électroniques, comprenant les étapes suivantes :
application d'un liquide test qui contient un colorant réagissant avec les résidus liquides acides par un changement de couleur, sur le composant électronique,
rinçage du liquide test depuis le composant électronique, et
détection des zones de surface du composant électronique qui sont colorées de façon correspondante au changement de couleur,
**caractérisé en ce que** le liquide test contient du bleu du Nil à titre de colorant et un agent tensioactif pour améliorer la capacité de mouillage du liquide test.

2. Procédé selon la revendication 1, dans lequel l'agent tensioactif est un polyglycol-éther.

3. Procédé selon la revendication 2, dans lequel l'agent tensioactif est un C₁₂/C₁₅-oxoalcoolpolyglycol-éther.

4. Procédé selon la revendication 3, dans lequel le oxoalcoolpolyglycol-éther contient de trois à cinq unités d'oxyde d'éthylène.

5. Procédé selon la revendication 1, dans lequel l'agent tensioactif est un agent tensioactif au fluor.

6. Procédé selon la revendication 5, dans lequel l'agent tensioactif au fluor a pour formule générale R_{f}CH₂CH₂O(CH₂CH₂O)ₓH, dans laquelle 3 ≤ x ≤ 5 et R_{f} = F(CF₂-CF₂)ₙ avec 3 ≤ n ≤ 8.

7. Procédé selon l'une des revendications 1 à 6, dans lequel le liquide test présente la composition suivante (exprimée en pourcentage pondéral) :
bleu du Nil : 0,02 à 0,06
agent tensioactif : 0,05 à 0,2
eau dessalée : qsp 100.

8. Liquide test pour la mise en évidence de résidus liquides acides sur des composants électroniques, qui contient du bleu du Nil comme colorant et un agent tensioactif choisi parmi des polyglycol-éthers ou des agents tensioactifs au fluor.

9. Liquide selon la revendication 8, dans lequel l'agent tensioactif est un polyglycol-éther.

10. Liquide selon la revendication 9, dans lequel l'agent tensioactif est un C₁₂/C₁₅-oxoalcoolpolyglycol-éther.

11. Liquide selon la revendication 10, dans lequel le oxoalcoolpolyglycol-éther contient de trois à cinq unités d'oxyde d'éthylène.

12. Liquide selon la revendication 8, dans lequel l'agent tensioactif est un agent tensioactif au fluor.

13. Liquide selon la revendication 12, dans lequel l'agent tensioactif au fluor a pour formule générale R_{f}CH₂CH₂O(CH₂CH₂O)ₓH, dans laquelle 3 ≤ x ≤ 5 et R_{f} = F(CF₂-CF₂)ₙ avec 3 ≤ n ≤ 8.

14. Liquide selon l'une des revendications 8 à 13, présentant la composition suivante (exprimée en pourcentage pondéral) :
bleu du Nil: 0,02 à 0,06
agent tensioactif : 0,05 à 0,2
eau dessalée : qsp 100.
